# EUROPÄISCHE PATENTSCHRIFT

(11) **EP 1 006 768 B1**
(45) Veröffentlichungstag und Bekanntmachung des Hinweises auf die Patenterteilung: **05.03.2003**
(21) Anmeldenummer: 99122644.0
(22) Anmeldetag: 13.11.1999
(51) Int. Cl.: H05K 7/14

(54) **Feldbusanschlusseinrichtung**
Field bus module
Dispositif bus de secteur

(30) Priorität: 03.12.1998 DE 19855869
(43) Veröffentlichungstag der Anmeldung: 07.06.2000
(73) Patentinhaber: K.A. SCHMERSAL GmbH & Co., D-42279 Wuppertal (DE)
(72) Erfinder: Lausberg, Gerd, 44287 Dortmund (DE); Cevik, Yasar, 58095 Hagen (DE)
(74) Vertreter: Sparing - Röhl - Henseler Patentanwälte

(56) Entgegenhaltungen:
- DE-A- 4 437 316
- DE-A- 19 616 551

## Beschreibung

Die Erfindung betrifft eine Feldbusanschlußeinrichtung nach dem Oberbegriff des Anspruchs 1.

Feldbusanschlußeinrichtungen dienen zur Verbindung von Sensoren und Aktoren mit einem seriellen Bussystem. Bekannte Feldbusanschlußeinrichtungen nehmen in einem im wesentlichen quaderförmigen Gehäuse eine bodenseitig abgestützte Basisplatine auf. An einer Seite des Gehäuses ist eine Vielzahl von Anschlußelementen fest mit dem Gehäuse verbunden, über die die Sensoren und Aktoren sowie das serielle Bussystem an die Basisplatine anschließbar sind. Zum Anschluß der Sensoren und Aktoren bzw. des seriellen Bussystems an das Gehäuse existieren verschiedene Anschlußtechniken, wobei die Anschlußelemente z. B. als Kabeldurchführungsanschlüsse, Steckverbindungen oder Steck-/Schraubverbindungen ausgebildet sind. Da jedoch die jeweiligen Anschlußelemente fest mit dem Gehäuse verbunden sind, haben solche Feldbusanschlußeinrichtungen den Nachteil, daß die jeweilige Anschlußtechnik für jedes Gehäuse festgelegt ist und daß bei Defekten eines oder mehrerer Anschlußelemente die gesamte Feldbusanschlußeinrichtung ausgetauscht werden muß.

Aus DE 44 37 316 A1 ist eine Feldbusanschlußeinrichtung bekannt, bei der eine Vielzahl von Anschlußelementen an eine als Signalverarbeitungseinrichtung ausgebildete Basisplatine anschließbar sind, die in einem quaderförmigen Gehäuse angeordnet ist. Hierbei sind jeweils mehrere Anschlußelemente in einem Modul angeordnet, wobei die Module über Steckverbinder zum Aufstecken auf an der Basisplatine vorgesehene Gegensteckverbinder verfügen, also einzeln ausgewechselt werden können.

Bei einer solchen Feldbusanschlußeinrichtung können zwar die Module jeweils einzeln ausgewechselt werden, jedoch ist dann die Basisplatine mit der zugehörigen Elektronik frei von außen zugänglich, so daß die Gefahr von Beschädigungen oder Manipulationen an der Elektronik durch den Benutzer besteht. Außerdem ist für jeden Steckplatz auf der Basisplatine die Ausgestaltung der Module weitgehend vorgegeben, so daß unterschiedliche Anschlußtechniken nicht beliebig kombinierbar sind.

Aus DE 39 33 099 A1 ist ein modulares Aufbausystem bekannt, bei dem auf einer isolierten Bus-Leiterplatte mehrere Gehäuse mit eingesetzten und über Halteklinken verriegelte Baugruppen aufgesteckt sind. Infolge der geschlossenen Baugruppen ist ein beliebiger Austausch von unterschiedlichen Anschlußelementen ist nicht möglich. Femer ist auch in dieser Vorrichtung bei einem Auswechseln der Baugruppen die Bus-Leiterplatte frei zugänglich.

Aus DE 197 16 137 C1 und DE 296 07 525 U1 sind jeweils Anschlußvorrichtungen zum Anschluß von Aktoren und/oder Sensoren bekannt, die ein oder mehrere auf ein Unterteil aufsetzbare Oberteile mit einer Vielzahl von Anschlußelementen für die Sensoren und Aktoren aufweisen. Ferner ist aus DE 196 15 093 A1 eine serielle Schnittstelle für Feldbusse bekannt, die ein Automatisierungsgerät mit einem auf einen Steckverbinder aufsteckbaren Kommunikationsadapter aufweist. Die Realisierung unterschiedlicher Anschlußtechniken durch Auswechseln einzelner Anschlüsse ist bei diesen Vorrichtungen weder vorgesehen noch möglich.

Aus DE 44 12 270 C2 schließlich ist ein dezentraler, modular aufgebauter Schnittstellenbaustein für ein Bus-System bekannt, bei dem die Steuerelektronikeinheit mit unterschiedlich bestückten Anschlußträgern zur Anpassung an unterschiedliche Anschlußtechniken zusammengesteckt werden kann. Die Steuerelektronik ist jedoch hierbei zwangsläufig frei zugänglich und somit der Gefahr durch Beschädigungen oder Manipulationen ausgesetzt.

Aufgabe der Erfindung ist es, eine Feldbusanschlußeinrichtung nach dem Oberbegriff des Anspruchs 1 zu schaffen, bei der unterschiedliche Abschlußtechniken beliebig kombinierbar bzw. austauschbar sind und gleichzeitig bei einem solchen Austausch die Elektronik vor Beschädigungen und Manipulationen geschützt ist.

Diese Aufgabe wird entsprechend dem kennzeichnenden Teil des Anspruchs 1 gelöst.

Hierzu umfassen bei einer Feldbusanschlußeinrichtung mit einer in einem im wesentlichen quaderförmigen Gehäuse bodenseitig angeordneten Basisplatine und einer Vielzahl von mindestens ein Anschlußelement über eine Modulträgerplatte aufnehmenden Modulen zum Anschluß an die Basisplatine, wobei das Gehäuse anschlußelementenseitig mehrere Aufnahmen für jeweils ein Modul aufweist und jedes Modul über eine auf die Basisplatine aufgesteckte Steckverbinderleistenanordnung mit dieser lösbar gekoppelt ist, die Module jeweils eine mit der jeweiligen Modulträgerplatte verbundene, entsprechend dem mindestens einen Anschlußelement ausgelegte Modulplatine, die das Modul über die Steckverbinderleistenanordnung mit der Basisplatine koppelt, und die Aufnahmen weisen jeweils einen anschlußelementenseitig offenen Aufnahmeraum für jeweils ein Modul mit bodenseitigen Öffnungen für die Steckverbinderleistenanordnung auf.

Da die Module mit der Basisplatine nicht direkt, sondern über entsprechend den jeweiligen Anschlußelementen ausgelegte Modulplatinen gekoppelt sind, lassen sich unterschiedliche Anschlußtechniken wie z.B. Kabeldurchführungsanschlüsse einfach realisieren und beliebig kombinieren, da mit dem Anschlußelement nur die jeweilige Modulplatine ausgewechselt werden muß. Gleichzeitig ist bei einem solchen Austausch infolge der für jedes Modul eigens vorgesehenen Aufnahmeräume die Basisplatine mit der zugehörigen Elektronik keinem Zugriff durch den Benutzer ausgesetzt. Hierdurch wird außerdem eine einzelne Abdichtung der Module gegen das Gehäuse ermöglicht und damit eine erhöhte Schutzklasse erreicht.

Vorzugsweise sind die Modulträgerplatten über Spannelemente in den Aufnahmen lösbar befestigt, wobei ein Lösen bzw. Befestigen der Modulträgerplatten z.B. durch eine geringe Drehung von beispielsweise 90° des jeweiligen Spannelements vorgenommen werden kann.

Femer weisen die Aufnahmen für die Modulträgerplatten vorzugsweise einen vertieft angeordneten umlaufenden Auflagerand auf. Zwischen dem Auflagerand und der zugehörigen Modulträgerplatte ist außerdem vorzugsweise eine Flachdichtung eingelegt.

Weitere Ausgestaltungen der Erfindung sind der nachfolgenden Beschreibung und den Unteransprüchen zu entnehmen.

Die Erfindung wird nachstehend anhand von in den beigefügten Abbildungen dargestellten Ausführungsbeispielen näher erläutert.
Fig. 1 zeigt eine perspektivische Ansicht einer Feldbusanschlußeinrichtung.
Fig. 2 und 3 zeigen jeweils einen Teil der Feldbusanschlußeinrichtung aus Fig. 1 in einer Explosivdarstellung.
Fig. 4a bis 4f zeigen in Draufsicht Modulträgerplatten der Feldbusanschlußeinrichtung aus Fig. 1 mit unterschiedlichen Anschlußelementen.

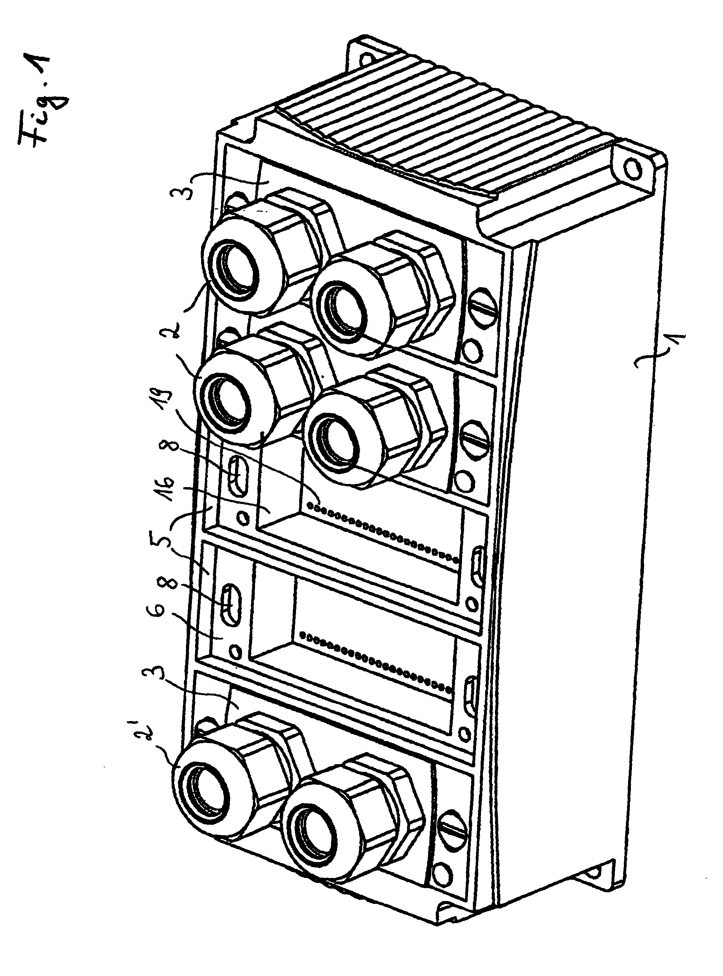

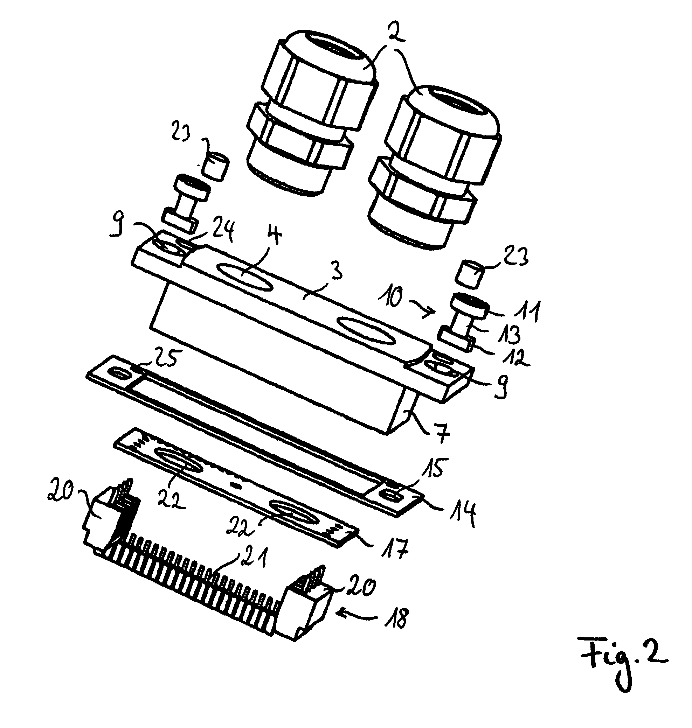

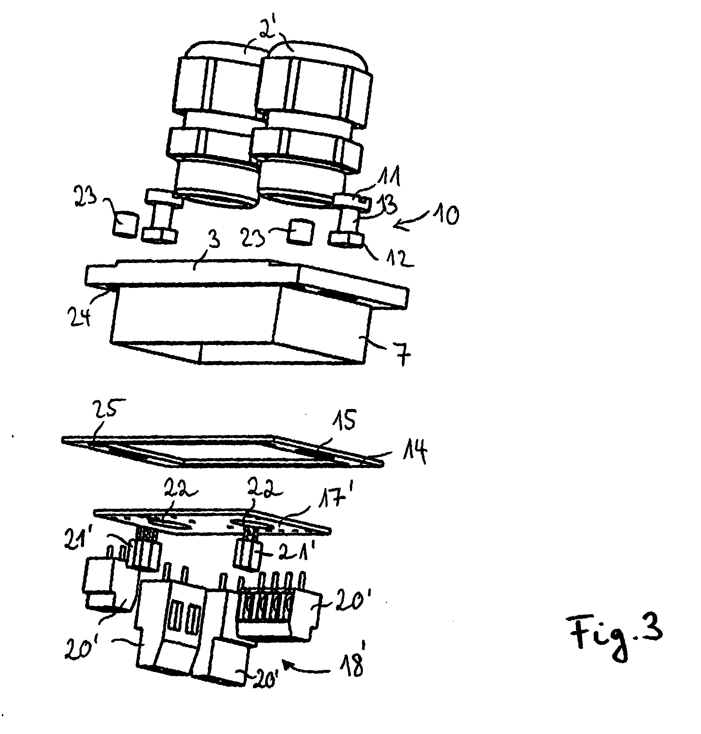

Gemäß Fig. 1 umfaßt eine Feldbusanschlußeinrichtung ein im wesentlichen quaderförmiges Gehäuse 1. Auf einer Seite des Gehäuses 1 sind mehrere im wesentlichen zylinderförmige Anschlußelemente 2, 2', die hier als Kabeldurchführungsanschlüsse ausgebildet sind, vorzugsweise paarweise angeordnet. Hierbei ist ein Paar von Anschlußelementen 2' (siehe Fig. 3) insbesondere zum Anschluß an einen seriellen Bus eines seriellen Bussystems vorgesehen, während die übrigen zwei Paare (siehe Fig. 2) von Anschlußelementen 2 zum Anschluß an Sensoren und Aktoren vorgesehen sind.

In dem Gehäuse 1 wird auf der den Anschlußelementen 2, 2' abgewandten Seite eine Basisplatine (nicht dargestellt) aufgenommen und abgestützt. Durch jedes der Anschlußelemente 2, 2' kann ein Kabel (nicht dargestellt) geführt sein, welches im Gehäuse 1 mit der Basisplatine elektrisch verbunden ist.

Gemäß Fig. 2 und 3 ist jedes Paar von Anschlußelementen 2, 2' jeweils an einer in Draufsicht rechteckigen Modulträgerplatte 3 befestigt. Vorzugsweise ist jedes Anschlußelement 2, 2' in eine jeweils in der Modulträgerplatte 3 vorgesehene Gewindebohrung 4 (Gewinde nicht dargestellt) eingeschraubt, die Anschlußelemente können jedoch auch mit der jeweiligen Modulträgerplatte 3 vergossen sein. Die Modulträgerplatten 3 sind identisch und in hierfür anschlußelementenseitig am Gehäuse 1 vorgesehene, identische Aufnahmen 5 eingesetzt, wobei zur besseren Verdeutlichung zwei Aufnahmen 5 in Fig. 1 unbesetzt sind. Vorzugsweise weisen die Aufnahmen 5 jeweils einen vertieft angeordneten Auflagerand 6 für die Modulträgerplatten 3 auf, wobei sich jeweils eine Modulträgerplatte 3 mit einem Fortsatz 7 in den Aufnahmeraum der jeweiligen Aufnahme 5 erstreckt.

Vorzugsweise sind die einzelnen Modulträgerplatten 3 jeweils gegen das Gehäuse 1 verspannt. Gemäß der in Fig. 1 bis 3 dargestellten Ausführungsform weisen die Aufnahmen 5 hierzu jeweils zwei im Auflagerand 6 vorgesehene Langlöcher 8 und die Modulträgerplatten 3 zwei jeweils hiermit korrespondierende Langlöcher 9 auf. Ferner sind Spannelemente 10 vorgesehen, wobei jedes Spannelement 10 einen Kopf 11 und ein Anschlagstück 12 aufweist, die über einen Schaft 13 verbunden sind. Durch die korrespondierenden Langlöcher 8, 9 einer Aufnahme 5 und einer eingesetzten Modulträgerplatte 3 ist jeweils eines der Spannelemente 10 hindurchgesteckt und in bezug auf die Aufnahme 5 bzw. die Modulträgerplatte 3 verdreht. Die Aufnahmen 5 weisen unterseitig benachbart zu den Langlöchern 8 jeweils eine Nockenfläche (nicht gezeigt) auf, wobei bei Verdrehung eines Spannelements 10 gegenüber der jeweiligen Aufnahme 5 das Anschlagstück 12 gegen die Nockenfläche gedrückt und somit die jeweilige Modulträgerplatte 3 mit der entsprechenden Aufnahme 5 verspannt wird. Auf diese Weise werden die Modulträgerplatten 3 jeweils in einer Aufnahme 5 über einen so gebildeten Bajonettverschluß lösbar an dem Gehäuse 1 befestigt. Alternativ können die Modulträgerplatten 3 jeweils auch über Klipsverschlüsse in den entsprechenden Aufnahmen 5 befestigt sein.

Vorzugsweise ist gemäß Fig. 2 und 3 zwischen dem Auflagerand 6 und der zugehörigen Modulträgerplatte 3 jeweils eine Flachdichtung 14 einlegt, so daß jede Modulträgerplatte 3 gegen das Gehäuse 1 jeweils einzeln abgedichtet ist. Jede Flachdichtung 14 weist ebenfalls zwei mit den Langlöchem 8, 9 der jeweiligen Aufnahme 5 und der jeweiligen Modulträgerplatte 3 fluchtende Langlöcher 15 auf.

Die Aufnahmen 5 weisen vorzugsweise jeweils einen Einsatz 16 zum Bilden jeweils eines Aufnahmeraums unterhalb der entsprechenden Aufnahme 5 auf. Hierdurch läßt sich in jeden Einsatz 16 jeweils eine Modulträgerplatte 3 einsetzen, ohne daß die Basisplatine mit der zugehörigen Elektronik von außen frei zugänglich ist.

Für jede Modulträgerplatte 3 ist jeweils eine entsprechend den auf dieser befestigten Anschlußelementen 2, 2' ausgelegte Modulplatine 17, 17' vorgesehen. Jede Modulplatine 17, 17' ist über eine auf der Basisplatine aufgesteckte und mit der Modulplatine 17, 17' verlötete Steckverbinderleistenanordnung 18, 18' mit der Basisplatine lösbar gekoppelt. Hierzu sind an der Basisplatine Steckerstifte oder Steckerbuchsen (nicht dargestellt) und in dem jeweiligen Einsatz 16 hierzu korrespondierende Bohrungen 19 angeordnet, so daß die Steckerstifte oder Steckerbuchsen aus den Bohrungen 19 emporragen und die betreffende Steckverbinderleistenanordnung 18, 18' hierauf aufsteckbar ist.

Gemäß Fig. 2 und 3 ist die Steckverbinderleistenanordnung 18, 18' unterschiedlich ausgebildet, je nachdem, ob sie zum Anschluß an Sensoren/Aktoren oder zum Anschluß an einen seriellen Bus vorgesehen ist. Infolge der perspektivischen Darstellung sind die Größenverhältnisse in Fig. 2 und 3 geringfügig verändert. Zur Verdeutlichung ist jeweils ein Paar von Anschlußelementen 2, 2' mit der zugehörigen Modulträgerplatte 3 und Modulplatine 17, 17' in Explosivdarstellung dargestellt, wobei die in Fig. 2 dargestellte Anordnung zum Anschluß an Sensoren/Aktoren und die in Fig. 3 dargestellte Anordnung zum Anschluß an einen seriellen Bus vorgesehen ist.

Die in Fig. 2 und 3 dargestellten Steckverbinderleistenanordnungen 18, 18' umfassen jeweils mit der jeweiligen Modulplatine 17, 17' verlötete Klemmenleisten 20, 20', in denen ein durch eine der Gewindebohrungen 4 geführtes Kabel abgedichtet eingeklemmt ist (nicht dargestellt). An jeder Modulplatine 17, 17' sind Leiterbahnen (nicht dargestellt) vorgesehen, die die Klemmenleisten 20, 20' mit den übrigen, auf die Steckerstifte oder Steckerbuchsen der Basisplatine aufgesteckten Steckverbinderleisten 21, 21' der Steckverbinderleistenanordnung 18, 18' elektrisch koppeln. Im Falle der Steckverbinderleistenanordnung 18 aus Fig. 2 kann zusätzlich zu dem Anschluß der Leitungen der Sensoren und Aktoren auch eine Versorgungsspannung für die Aktoren über die Klemmenleisten 20 eingespeist werden. Im Falle der Steckverbinderleistenanordnung 18' aus Fig. 3 werden außer den Leitungen zur Anschaltung eines seriellen Busses eine Versorgungsspannung für die Basisplatine und ggf. zusätzlich die Versorgungsspannung der Aktoren an die Klemmenleisten 20' angeschlossen.

Die Modulplatinen 17, 17' weisen für jedes der Anschlußelemente 2, 2' mit den Gewindebohrungen 4 (bzw. mit den einfachen Bohrungen ohne Gewinde) in der jeweiligen Modulträgerplatte 3 fluchtende Durchstecköffnungen 22 auf. Ein durch eine der Gewindebohrungen 4 geführtes Kabel ist auch durch die jeweilige Durchstecköffnung 22 geführt, erstreckt sich mit einem Ende durch das jeweilige Anschlußelement 2, 2' und ist mit dem anderen Ende in der jeweiligen Klemmenleiste 20, 20' eingeklemmt.

Bei Verwendung eines Steckverbindungsanschlusses oder Steck-/Schraubverbindungsanschlusses als Anschlußelement 2, 2' kann ebenfalls ein Kabel durch die Durchstecköffnungen 22 geführt werden, welches mit dem jeweiligen Steckverbindungsanschluß elektrisch verbunden ist, wobei es diesen mit der entsprechenden Klemmenleiste 20, 20' elektrisch verbindet. Alternativ kann der Steckverbindungsanschluß jedoch auch zweiteilig ausgebildet sein, wobei ein Unterteil mit der zugehörigen Modulplatine 17, 17' über eine Steckverbindung gekoppelt ist und ein mit dem Unterteil lösbar verbundenes Oberteil als Steckerelement dient.

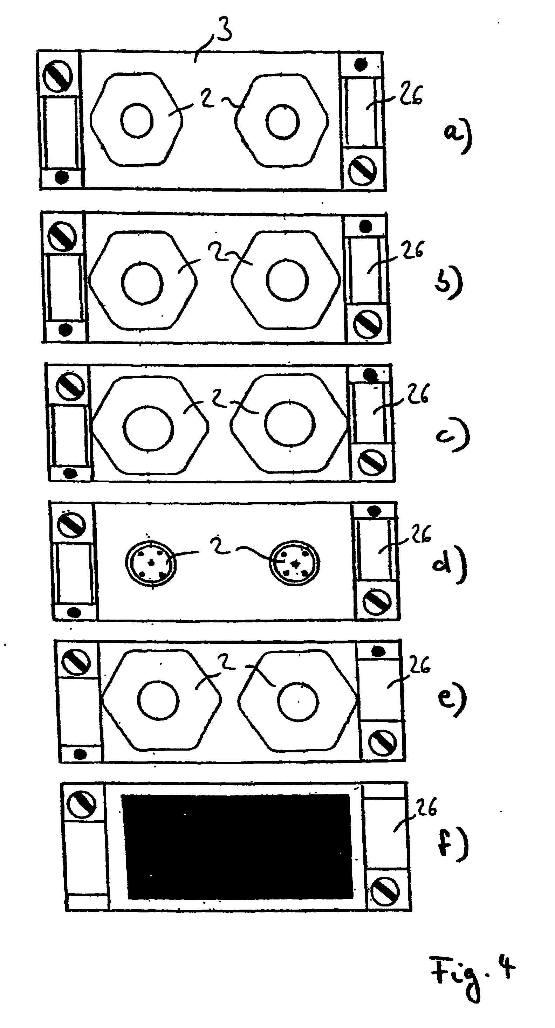

Gemäß Fig. 4a bis 4f können auch Anschlußelemente 2, 2' anderer Größe (Fig. 4a bis 4c) sowie andere Anschlußelemente 2, 2' wie Steckverbindungsanschlüsse (Fig. 4d), Schneidklemmanschlüsse (Fig. 4e), Steck-/Schraubverbindungsanschlüsse oder auch eine Kombination solcher Anschlußelemente verwendet werden. Ferner kann statt einer Modulträgerplatte 3 auch eine Blindplatte (Fig. 4f), z.B. für zusätzliche Elektronik oder Relais, eingesetzt werden.

Vorzugsweise ist für jede Modulträgerplatte 3 jeweils eine den Schaltzustand einer Sensor/Aktorverbindung anzeigende Leuchtanzeige (LED) mit der Basisplatine elektrisch verbunden. Jede der Modulträgerplatten 3 weist jeweils einen benachbart zur jeweiligen Leuchtanzeige angeordneten transparenten Einsatz 23 auf, der in jeweils eigens hierfür vorgesehenen Bohrungen 24, 25 in der betreffenden Modulträgerplatte 3 bzw. der Flachdichtung 14 angeordnet ist, wobei er beim Verspannen der Modulträgerplatte 3 gegen das Gehäuse 1 gegen die Modulträgerplatte 3 abgedichtet wird. Wahlweise können Leuchtanzeigen auch direkt im Gehäuse 1 untergebracht sein.

Gemäß Fig. 4a bis 4f können die Modulträgerplatten 3 außerdem jeweils einen Steckplatz 26 für ein Beschriftungsschild umfassen.

Vorzugsweise sind die Modulträgerplatten 3 oder das Gehäuse 1 gegen Verdrehen und Vertauschen mechanisch oder elektrisch kodiert.

## Patentansprüche

1. Feldbusanschlußeinrichtung mit einer in einem im wesentlichen quaderförmigen Gehäuse (1) bodenseitig angeordneten Basisplatine und einer Vielzahl von mindestens ein Anschlußelement (2, 2') über eine Modulträgerplatte (3) aufnehmenden Modulen zum Anschluß an die Basisplatine, wobei das Gehäuse (1) anschlußelementenseitig mehrere Aufnahmen (5) für jeweils ein Modul aufweist und jedes Modul über eine auf die Basisplatine aufgesteckte Steckverbinderleistenanordnung (18, 18') mit dieser lösbar gekoppelt ist, **dadurch gekennzeichnet, daß** die Module jeweils eine mit der jeweiligen Modulträgerplatte (3) verbundene, entsprechend dem mindestens einen Anschlußelement (2, 2') ausgelegte Modulplatine (17, 17'), die das Modul über die Steckverbinderleistenanordnung (18, 18') mit der Basisplatine koppelt, umfassen und die Aufnahmen (5) jeweils einen anschlußelementenseitig offenen Aufnahmeraum für jeweils ein Modul mit bodenseitigen Öffnungen (19) für die Steckverbinderleistenanordnung (18, 18') aufweisen.

2. Feldbusanschlußeinrichtung nach Anspruch 1, **dadurch gekennzeichnet, daß** die Modulträgerplatten (3) über Spannelemente (10) in den Aufnahmen (5) lösbar befestigt sind.

3. Feldbusanschlußeinrichtung nach Anspruch 2, **dadurch gekennzeichnet, daß** die Aufnahmen (5) und die Modulträgerplatten (3) korrespondierende Langlöcher (8, 9) für jeweils ein Spannelement (10) aufweisen.

4. Feldbusanschlußeinrichtung nach Anspruch 3, **dadurch gekennzeichnet, daß** unterseitig zu den Aufnahmen (5) jeweils ein Anschlag für das jeweilige Spannelement (10) vorgesehen ist.

5. Feldbusanschlußeinrichtung nach Anspruch 1, **dadurch gekennzeichnet, daß** die Modulträgerplatten (3) über Klipsverschlüsse in den Aufnahmen (5) befestigt sind.

6. Feldbusanschlußeinrichtung nach einem der Ansprüche 1 bis 5, **dadurch gekennzeichnet, daß** die Steckverbinderleistenanordnung (18, 18') Klemmenleisten (20, 20') umfaßt.

7. Feldbusanschlußeinrichtung nach Anspruch 6, **dadurch gekennzeichnet, daß** die Modulträgerplatten (3) und die Modulplatinen (17, 17') für wenigstens einen Teil der Anschlußelemente (2, 2') fluchtende Durchstecköffnungen (4, 22) aufweisen, durch die ein das jeweilige Anschlußelement (2, 2') mit einer entsprechenden Klemmenleiste (20, 20') elektrisch verbindendes Kabel geführt ist.

8. Feldbusanschlußeinrichtung nach Anspruch 7, **dadurch gekennzeichnet, daß** die Durchstecköffnungen (4) der Modulträgerplatten (3) Gewindebohrungen sind, in die jeweils ein Anschlußelement (2, 2') einschraubbar ist.

9. Feldbusanschlußeinrichtung nach einem der Ansprüche 1 bis 5, **dadurch gekennzeichnet, daß** wenigstens ein Teil der Anschlußelemente (2, 2') ein über eine Steckverbindung mit der zugehörigen Modulplatine (17, 17') gekoppeltes Unterteil sowie ein mit diesem lösbar verbundenes als Steckerelement dienendes Oberteil aufweist.

10. Feldbusanschlußeinrichtung nach einem der Ansprüche 1 bis 9, **dadurch gekennzeichnet, daß** die Aufnahmen (5) jeweils einen vertieft angeordneten umlaufenden Auflagerand (6) für die Modulträgerplatten (3) aufweisen.

11. Feldbusanschlußeinrichtung nach Anspruch 10, **dadurch gekennzeichnet, daß** jeweils zwischen dem Auflagerand (6) und der zugehörigen Modulträgerplatte (3) eine Flachdichtung (14) eingelegt ist.

12. Feldbusanschlußeinrichtung nach Anspruch 10 oder 11, **dadurch gekennzeichnet, daß** wenigstens ein Teil der Modulträgerplatten (3) einen entsprechend dem jeweiligen Auflagerand (6) ausgelegten Fortsatz (7) aufweist.

13. Feldbusanschlußeinrichtung nach einem der Ansprüche 1 bis 12, **dadurch gekennzeichnet, daß** die Anschlußelemente (2, 2') Kabeldurchführungsanschlüsse, Steckverbindungsanschlüsse, Steck-/Schraubverbindungsanschlüsse und/oder Schneidklemmanschlüsse umfassen.

14. Feldbusanschlußeinrichtung nach einem der Ansprüche 1 bis 13, **dadurch gekennzeichnet, daß** die Modulträgerplatten (3) jeweils einen Steckplatz (26) für ein Beschriftungsschild umfassen.

15. Feldbusanschlußeinrichtung nach einem der Ansprüche 1 bis 14, **dadurch gekennzeichnet, daß** die Anschlußelemente (2, 2') zum Anschluß eines seriellen Bussystems sowie einer Vielzahl von Sensoren und Aktoren ausgelegt sind.

16. Feldbusanschlußeinrichtung nach einem der Anspruch 15, **dadurch gekennzeichnet, daß** die Modulträgerplatten (3) jeweils eine Leuchtanzeige für den Schaltzustand einer Sensor/Aktorverbindung umfassen.

17. Feldbusanschlußeinrichtung nach einem der Ansprüche 1 bis 16, **dadurch gekennzeichnet, daß** die Modulträgerplatten (3) oder das Gehäuse (1) gegen Verdrehen und Vertauschen mechanisch oder elektrisch kodiert sind.

## Claims

1. Field bus module with a base circuit board arranged at the bottom of a substantially parallel piped casing (1) and a plurality of modules holding at least one terminal element (2, 2') by means of a module carrier plate (3), for connecting to the base circuit board, whereby the casing (1) has on the side of the terminal elements several locations (5), each for one module, each module being detachably coupled to the base circuit board by means of a multipoint connector assembly (18, 18') plugged over it, **characterised in that** each module has a module circuit board (17, 17') connected to the respective module carrier plate (3) designed to suit at least one terminal element (2, 2'), which couples the module to the base circuit board via the multipoint connector assembly (18, 18'), each location (5) having a space open to the side of the terminal element, for one module with apertures (19) at the bottom for the multipoint connector arrangement (18, 18').

2. Field bus module according to claim 1, **characterised in that** the module carrier plates (3) are detachably affixed in the locations (5) by means of clamping elements (10).

3. Field bus module according to claim 2, **characterised in that** the locations (5) and the module carrier plates (3) have corresponding slots (8, 9) for each clamping element (10).

4. Field bus module according to claim 3, characterised that there is a stop for each respective clamping element (10) at the bottom of each location (5).

5. Field bus module according to claim 1, **characterised in that** the module carrier plates (3) are held in the locations (5) by means of locking clips.

6. Field bus module according to one of the claims 1 to 5, **characterised in that** the multipoint connector arrangement (18, 18') comprises terminal blocks (20, 20').

7. Field bus module according to claim 6, **characterised in that** the module carrier plates (3) and the module circuit boards (17, 17) have through holes (4, 22) aligned to each other, for at least a part of the terminal elements (2, 2'), through which a cable connecting the respective connecting element (2, 2') to the appropriate terminal block (20, 20') is carried.

8. Field bus module according to claim 7, **characterised in that** the through holes (4) in the module carrier plates (3) are threaded holes into which the respective terminal element (2, 2') can be screwed.

9. Field bus module according to one of the claims 1 to 5, **characterised in that** at least part of the terminal elements (2, 2') has a lower part coupled to the appropriate module circuit board (17, 17') by means of a plug-in connection and a detachably connected upper part serving as a plug-in element.

10. Field bus module according to one of the claims 1 to 9, **characterised in that** the locations (5) have in each case a recessed all-round supporting edge (6) for the module carrier plates (3).

11. Field bus module according to claim 10, **characterised in that** a flat seal (14) is placed in each case between the supporting edge (6) and the module carrier plates (3).

12. Field bus module according to claim 10 or 11, **characterised in that** at least some of the module carrier plates (3) have a projection (7) designed to match the respective supporting edge (6).

13. Field bus module according to one of the claims 1 to 12, **characterised in that** the terminal elements (2, 2') include cable bushing connections, plug-in connections, plug-in/screwed connections and/or insulation displacement connectors.

14. Field bus module according to one of the claims 1 to 13, **characterised in that** each module carrier plate (3) includes a space (26) for inserting a code label.

15. Field bus module according to one of the claims 1 to 14, **characterised in that** the terminal elements (2, 2') are designed for connecting a serial bus system and a plurality of sensors and actors.

16. Field bus module according to claim 15, **characterised in that** each module carrier plate (3) has an indicator light indicating the switched state of a sensor/actor connection.

17. Field bus module according to one of the claims 1 to 16, **characterised in that** the module carrier plates (3) or the casing (1) are mechanically or electrically coded against wrong alignment or misplacement.

## Revendications

1. Dispositif de raccordement de bus mobile avec une platine de base disposée côté fond dans un boîtier (1) essentiellement parallélépipédique et une pluralité de modules destinés à être raccordés à la platine de base, recevant au moins un élément de raccordement (2, 2') par l'intermédiaire d'une plaque support de module (3), le boîtier (1) présentant, côté élément de raccordement, plusieurs logements (5) prévus chacun pour un module et chaque module étant accouplé par l'intermédiaire d'un agencement de barrette de connecteurs à fiche (18, 18') monté sur la platine de base, de manière séparable avec ledit agencement, **caractérisé en ce que** les modules comprennent chacun une platine de module (17, 17') reliée à la plaque support de module (3) correspondante, conçue de manière correspondant à l'élément de raccordement (2, 2') au moins unique et accouplant le module avec la platine de base par l'intermédiaire de l'agencement de barrette de connecteurs à fiche (18, 18') et **en ce que** les logements (5) présentent chacun un espace de logement ouvert côté élément de raccordement pour chacun un module avec des ouvertures (19) côté fond pour l'agencement de barrette de connecteurs à fiche (18, 18').

2. Dispositif de raccordement de bus mobile selon la revendication 1, **caractérisé en ce que** les plaques supports de modules (3) sont fixées de manière séparable dans les logements (5) par l'intermédiaire d'éléments de serrage (10).

3. Dispositif de raccordement de bus mobile selon la revendication 2, **caractérisé en ce que** les logements (5) et les plaques supports de modules (3) présentent des trous oblongs correspondants (8, 9) pour chaque élément de serrage (10).

4. Dispositif de raccordement de bus mobile selon la revendication 3, **caractérisé en ce qu'**il est prévu, au-dessous des logements (5), une butée pour l'élément de serrage (10).

5. Dispositif de raccordement de bus mobile selon la revendication 1, **caractérisé en ce que** les plaques supports de modules (3) sont fixées dans les logements (5) par l'intermédiaire de fermetures à clips.

6. Dispositif de raccordement de bus mobile selon l'une des revendications 1 à 5, **caractérisé en ce que** l'agencement de barrette de connecteurs à fiches (18, 18') comprend des barrettes à bornes (20, 20').

7. Dispositif de raccordement de bus mobile selon la revendication 6, **caractérisé en ce que** les plaques supports de modules (3) et les platines de modules (17, 17') présentent, pour au moins une partie des éléments de raccordement (2, 2'), des ouvertures traversantes alignées (4, 22), par lesquelles passe un câble reliant électriquement l'élément de raccordement (2, 2') à une barrette à bornes correspondante (20, 20').

8. Dispositif de raccordement de bus mobile selon la revendication 7, **caractérisé en ce que** les ouvertures traversantes (4) des plaques supports de module (3) sont des orifices filetés dans lesquels un élément de raccordement (2, 2') peut être vissé.

9. Dispositif de raccordement de bus mobile selon l'une des revendications 1 à 5, **caractérisé en ce qu'**au moins une partie des éléments de raccordement (2, 2') présente une pièce inférieure accouplée par l'intermédiaire d'un connecteur à fiche avec la platine de module correspondante (17, 17'), ainsi qu'une pièce supérieure reliée de manière séparable avec la pièce inférieure et servant d'élément à fiche.

10. Dispositif de raccordement de bus mobile selon l'une des revendications 1 à 9, **caractérisé en ce que** les logements (5) présentent chacun un bord d'appui (6) périphérique, disposé en creux, pour les plaques supports de module (3).

11. Dispositif de raccordement de bus mobile selon la revendication 10, **caractérisé en ce qu'**un joint plat (14) est logé entre le bord d'appui (6) et la plaque support de module correspondante (3).

12. Dispositif de raccordement de bus mobile selon la revendication 10 ou 11, **caractérisé en ce qu'**au moins une partie des plaques supports de module (3) présente un prolongement (7) conçu de manière correspondant au bord d'appui (6).

13. Dispositif de raccordement de bus mobile selon l'une des revendications 1 à 12, **caractérisé en ce que** les éléments de raccordement (2, 2') comprennent des raccordements pour des traversées de câbles, des raccordements de connecteurs à fiche, des raccordements de connecteurs à fiche/à vis, et/ou des raccordements de bornes guillotines.

14. Dispositif de raccordement de bus mobile selon l'une des revendications 1 à 13, **caractérisé en ce que** les plaques supports de modules (3) comprennent chacune un emplacement (26) pour une plaque d'inscription.

15. Dispositif de raccordement de bus mobile selon l'une des revendications 1 à 14, **caractérisé en ce que** les éléments de raccordement (2, 2') sont conçus pour le raccordement d'un système de bus série, ainsi que d'une pluralité de capteurs et actionneurs.

16. Dispositif de raccordement de bus mobile selon la revendication 15, **caractérisé en ce que** les plaques supports de modules (3) comprennent chacune un témoin lumineux indiquant l'état de branchement d'une liaison capteur/actionneur.

17. Dispositif de raccordement de bus mobile selon l'une des revendications 1 à 16, **caractérisé en ce que** les plaques supports de modules (3) ou le boîtier (1) sont codés mécaniquement et électriquement pour éviter la torsion et la permutation.
